# EUROPEAN PATENT APPLICATION

(11) **EP 2 518 923 A1**
(43) Date of publication of application: **31.10.2012**
(21) Application number: 11163754.2
(22) Date of filing: 26.04.2011
(51) Int. Cl.: H04L 1/00, H04L 27/34

(54) **Bit permutation patterns for BICM with LDPC codes of rate 2/5 and QAM constellations**

(71) Applicant: Panasonic Corporation, Kadoma-shi Osaka 571-8501 (JP)
(72) Inventor: Petrov, Mihail, 63225, Langen (DE)
(74) Representative: Grünecker, Kinkeldey, Stockmair & Schwanhäusser

(57) **Abstract**

The invention relates to a method for processing bits of a digital signal that are to be input to a QAM modulator, and also to a method for processing bits of a digital signal that are output by a QAM demodulator. A permutation processing respectively inverse permutation is performed on the bits so as to optimize the association of the bits with the QAM constellation symbols. The performance of the LDPC codes of code rate 1/3 and 2/5 is thus optimized. The invention provides various permutation rules for different QAM constellation sizes and different LDPC codes.

## Description

### FIELD OF THE INVENTION

The invention relates to a method for processing a digital signal in a transmitting side, and in particular to bit permutation patterns applied to bits before being input to the modulation block. Furthermore, the invention relates to a method for processing a digital signal in a receiving side, and in particular to bit permutation patterns applied to bits after being output by the demodulation block. Additionally, the invention relates to systems, i.e. transmitter and receiver, for performing the methods.

### TECHNICAL BACKGROUND

DVB-T2 (Digital Video Broadcasting - Second Generation Terrestrial) (ETSI EN 302.755) is an improvement of the television standard DVB-T, and describes a second generation baseline transmission system for digital terrestrial television broadcasting. It specifies the channel coding/modulation system intended for digital television services and generic data.

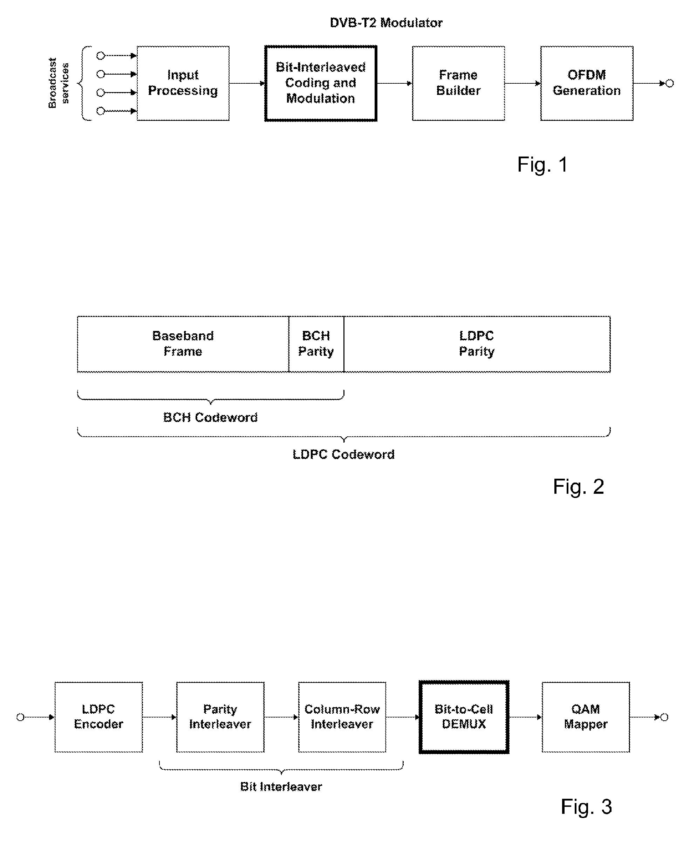

Fig. 1 shows a system overview of the DVB-T2 system architecture, including a block for bit-interleaved coding and modulation. Bit Interleaved coding and modulation (BICM) according to DVB-T2, Chapter 6, incorporated herein by reference, is explained in the following. Fig. 3 shows an abstract block diagram for the BICM encoder including the various relevant subsystems for processing data (without outer BCH encoding, constellation rotation, cell interleaver, time interleaver).

Basically, the procedure for BICM encoding according to DVB-T2 comprises the steps of: FEC (forward-error-correction) encoding, interleaving the bits of the resulting codeword, demultiplexing the interleaved bits into cell words, followed by mapping of said cell words onto complex QAM (quadrature amplitude modulation) symbols, which are also referred to as cells.

The FEC encoding is performed by concatenating a systematic BCH (Bose-Chaudhuri-Hocquenghem) outer encoder with a systematic LDPC (low-density parity check) inner encoder, as shown in Fig. 2. The length of the resulting codeword, also referred to as FEC frame, is 64000 or 16200 bits. The DVB-T2 standard specifies LDPC codes for both lengths. However, only length 16200 is relevant to the present invention as will be explained later.

The LDPC code provides most of the error-correction capability of the system, while the BCH code reduces the remaining error floor after LDPC decoding.

The bit interleaving comprises the steps of: interleaving the parity bits of the systematic LDPC codeword and interleaving the resulting codeword with a column-row interleaver. Subsequently, the resulting bits are demultiplexed to cells prior to mapping to QAM constellations. The demultiplexing is equivalent to a permutation of the columns of the column-row interleaver, and is referred to as bit-to-cell DEMUX in Fig. 3, which gives an overview of the BICM encoding.

The subsequent processing steps, such as the constellation rotation, the cell interleaving or the time interleaving will not be discussed in detail, in order to facilitate the explanation and in view of not being of relevance for the understanding of the principles of the invention.

LDPC codes are linear error correction codes for transmitting a message over a noisy transmission channel. They are finding increasing use in applications where reliable and highly efficient information transfer over bandwidth or return-channel constrained links in the presence of data-corrupting noise is desired. LDPC codes are defined by a sparse parity-check matrix.

The LDPC encoder of DVB-T2 treats the output of the BCH encoding as an information block and systematically encodes it onto an LDPC codeword. The task of the LDPC encoder is to compute the parity bits for every block of information bits, input to the LDPC encoder, i.e. for every BCH codeword. The processing of the LDPC encoder uses the particular codes as listed in tables A.1 through A.6 of the DVB-T2 standard 302.755.

It should be noted that the bits of an LDPC codeword have different importance levels, while the bits of a QAM constellation have different robustness levels. A straightforward (i.e. non-interleaved) mapping of the LDPC codeword bits to the constellation symbols leads to a suboptimal performance. This is the reason why a bit interleaver is typically used between the LDPC encoder and the constellation mapper. In other words, the bit interleaver allows achieving an improved association between the bits of the encoded LDPC codeword and the bits carried by the QAM constellations.

The different importance levels of the bits of an LDPC codeword results from the fact that not all these bits are involved in the same number of parity-checks, as defined by the parity-check matrix. The more parity-checks (i.e. check nodes) a bit (i.e. variable node) is connected to, the more important that bit is in the iterative decoding process. This aspect is well understood in the art.

Likewise, the different robustness levels of the bits encoded in a QAM constellation is a fact well known by the person skilled in the art. For example, a 16QAM constellation encodes four bits and has two robustness levels. A 64QAM constellation encodes six bits and has three robustness levels. A 256QAM constellation encodes eight bits and has four robustness levels.

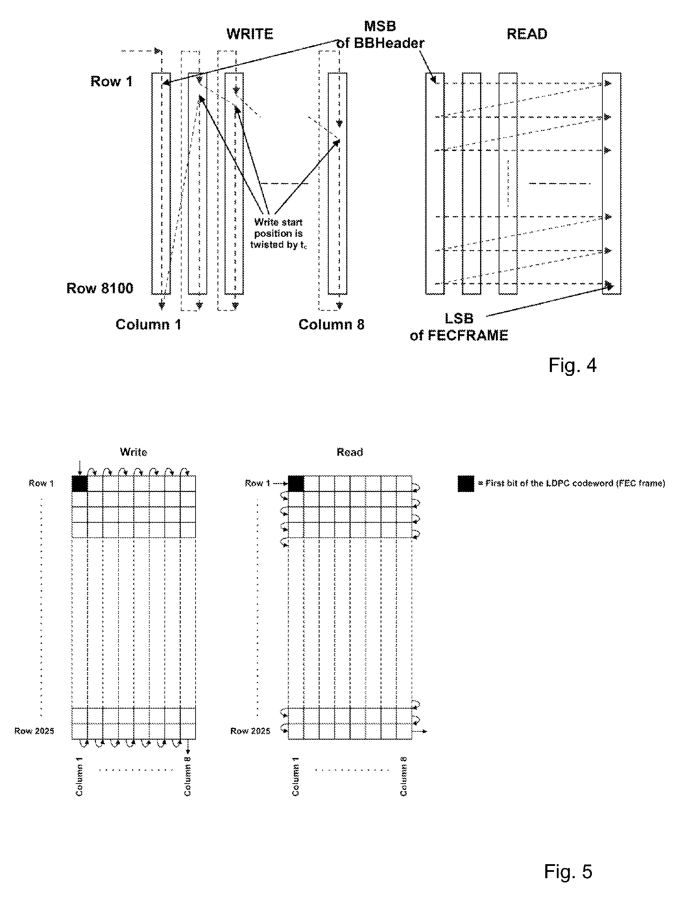

Further to the DVB-T2 standard, the column-row interleaver component of the bit interleaver works by serially writing the data bits uᵢ from the parity interleaver into an interleaver matrix , cyclically shifting (referred to as twisting) each column by a specified number of bits (as depicted in Fig. 4), and serially reading out the bits row-wise. The first bit of the LDPC codeword (FEC frame) is written and read out first as shown in Fig. 4. The parity interleaver output is U and the column twist interleaver output is denoted by V.

Therefore, a matrix with N_{c} columns and Nᵣ rows is defined. These two parameters are listed in the following table for all relevant constellation sizes and LDPC codes of length 16200. In DVB-T2 a column-row interleaver is not used for QPSK constellations.

| **Modulation** | **Columns N_{c}** | **Rows Nᵣ** |
|---|---|---|
| 16QAM | 8 (2 x 4) | 2025 |
| 64QAM | 12 ( 2 x 6) | 1350 |
| 256QAM | 8 (1 x 8) | 2025 |

The write start position of every column is twisted (i.e. cyclically shifted) by t_{c} according to the following table.

| **Modulation** | **Columns *N*_{c}** | ***N*_{ldpc}** | **Twisting parameter *t*_{c}** | | | | | | | | | | | | | | | |
|---|---|---|---|---|---|---|---|---|---|---|---|---|---|---|---|---|---|---|
| | | | **Col. 0** | **1** | **2** | **3** | **4** | **5** | **6** | **7** | **8** | **9** | **10** | **11** | **12** | **13** | **14** | **15** |
| 16-QAM | 8 | 64800 | 0 | 0 | 2 | 4 | 4 | 5 | 7 | 7 | - | - | - | - | - | - | - | - |
| | | 16200 | 0 | 0 | 0 | 1 | 7 | 20 | 20 | 21 | - | - | - | - | - | - | - | - |
| 64-QAM | 12 | 64800 | 0 | 0 | 2 | 2 | 3 | 4 | 4 | 5 | 5 | 7 | 8 | 9 | - | - | - | - |
| | | 16200 | 0 | 0 | 0 | 2 | 2 | 2 | 3 | 3 | 3 | 6 | 7 | 7 | - | - | - | - |
| 256-QAM | 16 | 64800 | 0 | 2 | 2 | 2 | 2 | 3 | 7 | 15 | 16 | 20 | 22 | 22 | 27 | 27 | 28 | 32 |
| | 8 | 16200 | 0 | 0 | 0 | 1 | 7 | 20 | 20 | 21 | - | - | - | - | - | - | - | - |

In the example of Fig. 4 it is assumed that a long frame with 64800 bits is generated by the BCH/LDPC encoder and that a 16QAM modulation is used. Correspondingly, the matrix has 8100 rows and 8 columns.

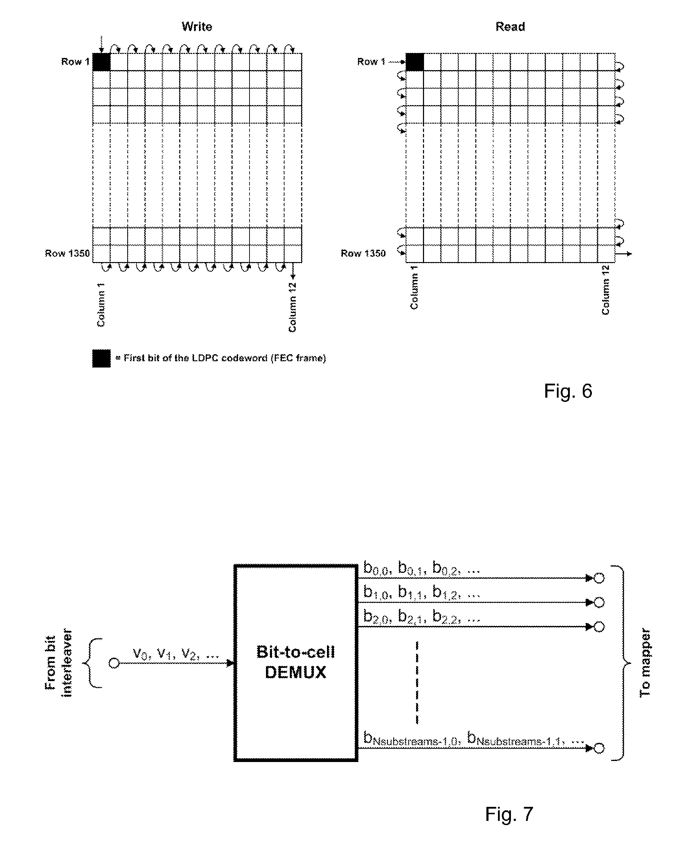

In the example of Fig. 5 and Fig. 6, the column-row interleaving process is shown for LDPC code words of length 16200, for a number of columns equal to 8 and 12 respectively. Only these two cases are relevant for the present invention as will be explained in more detail later.

Prior to the QAM mapping, each LDPC code block is first de-multiplexed into parallel cell words, each cell word containing as many bits as are encoded in one QAM constellation (η_{MOD}), that is, 2 bits for QPSK (4QAM), 4 bits for 16QAM, 6 bits for 64QAM, and 8 bits for 256QAM. The resulting number of QAM data cells per FEC block of length 16200 is therefore 16200/η_{MOD}, as follows. That is
8100 cells for QPSK,
4050 cells for 16QAM,
2700 cells for 64QAM, and
2025 cells for 256QAM.

The bit stream from the column-row interleaver is demultiplexed into substreams as shown in Fig. 7. The number of the substreams N_{substreams} is two for QPSK constellations and equal with the number of columns in the column-row interleaver for higher-order constellations (16QAM, 64QAM, 256QAM). In the latter case the demultiplexing also contains a bit permutation step, which is conceptually equivalent to a permutation of the columns of the column-row interleaver.

Fig. 8 illustrates the bit-to-cell DEMUX, and in particular the demultiplexing block and the permutation block of which it consists, and shows the inputs and outputs of the bit-to-cell DEMUX. Fig. 8 specifically refers to the case of 16QAM for which N_{subtreams}=8, where each substream has 16200/8=2025 bits (do = di div N_{substreams}). As apparent from Fig. 8, the output bits b₀₋₇ includes 2 cell words (y₀₋₃) that are then forwarded to the 16QAM modulator.

Fig. 9 illustrates the bit-to-cell DEMUX for the 64QAM modulation, where N_{subtreams}=12, and each substream has 16200/12=1350 bits. As apparent from Fig. 9, the output bits b₀₋₁₁ include 2 cell words (y₀₋₅), that are then forwarded to the 64QAM modulator.

Fig. 10 illustrates the bit-to-cell DEMUX for the 256QAM modulation, where N_{subtreams=}8, and each substream has 16200/8=2025 bits. As apparent from Fig. 10, the output bits b0-7 include one cell word y0-7 that is forwarded to the 256QAM modulator.

The bit-to-cell DEMUX is defined as a mapping of the bit-interleaved input bits v_{di} onto the output bits b_{e,do}, where:
- do = di div N_{substreams};
- e is the de-multiplexed bit substream number (0 ≤ e < N_{substreams});
- v_{di} is the input to the de-multiplexer;
- di is the input bit number;
- b_{e,do} is the output from the de-multiplexer;
- do is the bit number of a given stream at the output of the de-multiplexer.

Correspondingly, if the example configuration of Fig. 4 is assumed, with 16200 bits and 16QAM, 8 substreams would be formed (N_{substream}=8) according to the above table. Each substream has 16200/8 = 2025 bits (do=di div N_{substream}) and constitutes one column of the matrix.

The DVB-T2 standard defines such DEMUXes for all the available LDPC code rates in DVB-T2: 1/2, 3/5, 2/3, 3/4, 4/5, and 5/6 (see Tables 13(a, b, c) of EN 302.755 v1.2.1), and constellation modes: QPSK, 16QAM, 64QAM and 256 QAM. These parameters define permutations of the input bits to the output bits of a stream.

For instance, for LDPC blocks of length 16200 and a 16QAM modulation an input bit v_{di} is permuted to an output bit be according to the following rule (see Table 13(a) in EN 302.755 v1.2.1).
v₀=b₇, V₁=b₁, v₂=b₄, v₃=b₂, v₄=b₅, v₅=b₃, v₆=b₆, v₇=b₀

This permutation rule is optimized for code rates 1/2, 3/4, 4/5, and 5/6, such that the error rate at the output of the LDPC decoder in the receiver is minimized.

Except for QPSK (N_{ldpc} = 64 800 or 16 200) and 256-QAM (N_{ldpc}=16 200 only), the words of width N_{substreams} are split into two cell words of width η_{MOD}= N_{substreams} /2 at the output of the demultiplexer. The first η_{MOD} =N_{substreams}/2 bits [b₀,_{do}..b_{Nsubsireams/2-1,do}] form the first of a pair of output cell words [y_{0,2do}.. yη_{mod-1}, _{2do}] and the remaining output bits [b_{Nsubstreams/2, do}..b_{Nsubstreams}-_{1,do}] form the second output cell word [y_{0,2do+1}..yη_{mod-1,2do+1}] fed to the constellation mapper.

In the case of QPSK (N_{ldpc} = 64 800 or 16 200) and 256-QAM (N_{ldpc}=16 200 only), the words of width N_{substreams} from the demultiplexer form the output cell words and are fed directly to the constellation mapper, SO: [y_{0,do}..y_{ηmod-1,d0}] = [b_{0,do}..b_{Nsubstreams-1,do}]

In particular, the number of cell words involved in a DEMUX permutation is either 1 (for 256QAM) or 2 (for 16QAM and 64QAM).

Put differently, the DEMUX permutation is conceptually equivalent to a permutation of the columns in the column-row interleaver section of the bit-interleaver.

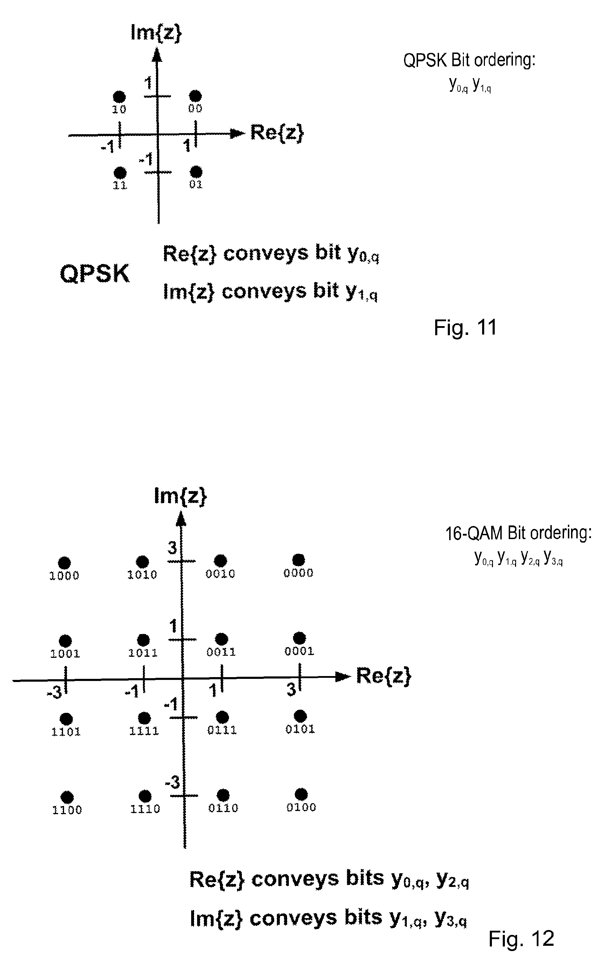

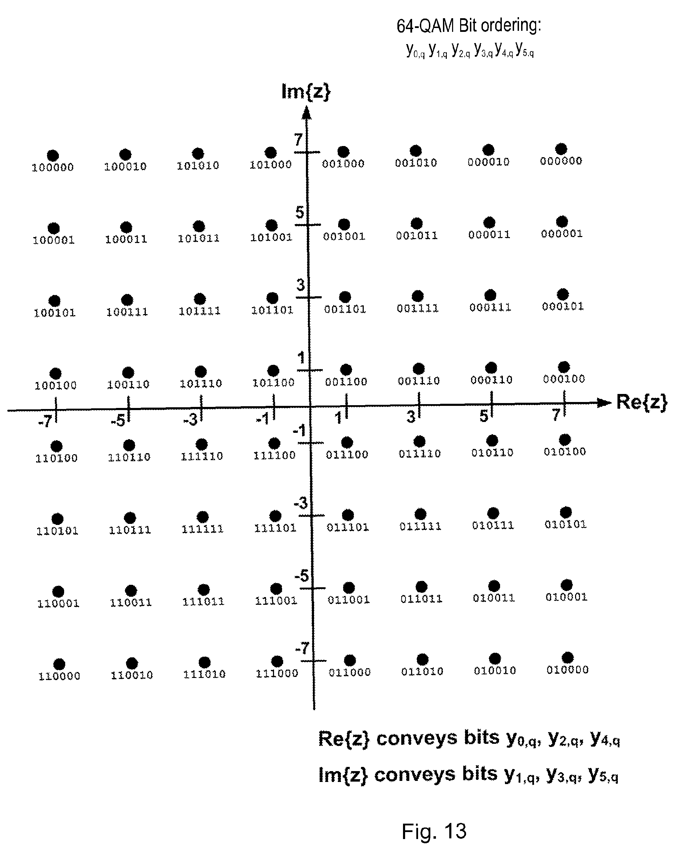

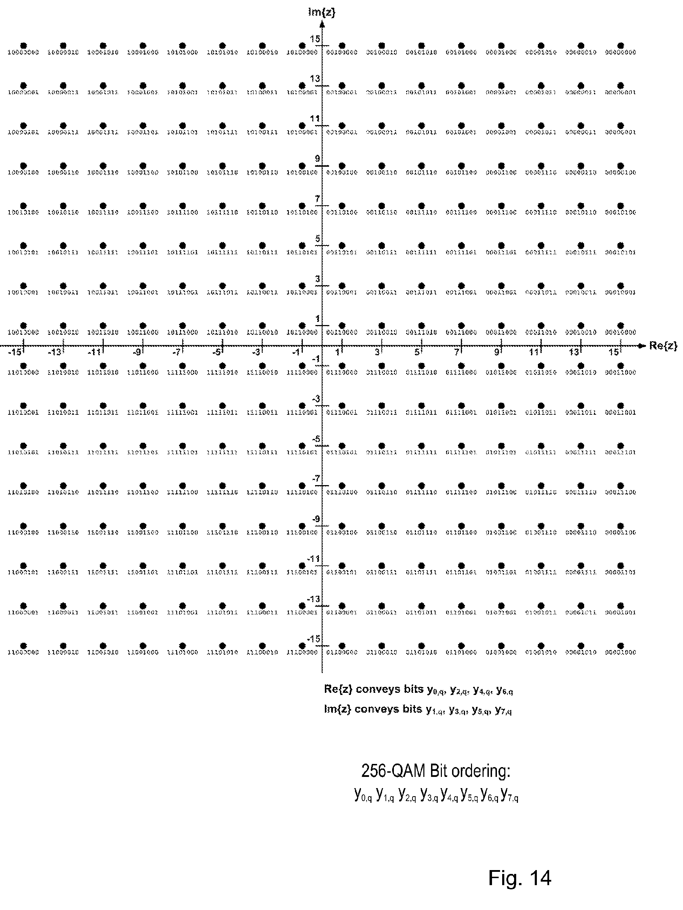

Subsequently, each cell word from the demultiplexer shall be modulated according to a particular mapping constellation such as QPSK, 16QAM, 64QAM or 256QAM. The constellations and the details of the Gray mapping applied to the bits according to DVB-T2 are illustrated in Fig. 11, 12, 13 and 14.

A subset of DVB-T2 for mobile reception is currently under discussion in the DVB standardization body. The mobile subset will use the same BICM structure as explained above, which comprises FEC encoding, bit interleaving, demultiplexing and QAM constellation mapping. Furthermore, two LDPC code rates, namely 1/3 and 2/5, are added in order to better cope with difficult mobile reception conditions. The same QAM constellations will remain, i.e. QPSK, 16QAM, 64QAM and 256QAM.

Only short 16k LDPC blocks, i.e. with 16200 bits, will be used in DVB-T2 mobile. It is not yet decided which LDPC codes will be used with respect to the newly introduced code rates of 1/3 and 2/5. Currently under discussion are the DVB-S2 16k LDPC codes as well as the new LDPC codes proposed by Sony.

DVB-S2 (ETSI EN 302.307) is a standard defining the coding and modulation for digital broadcasting via satellite. Like DVB-T2, the DVB-S2 standard uses LDPC codes for the forward error correction, and specifies LDPC codes for block lengths 64800 and 16200 (see Annex B and C of EN 302.307; incorporated herein by reference).

The candidate LDPC codes for DVB-T2 mobile, i.e. of block length 16200 and with code rates 1/3 and 2/5 are defined respectively in Tables C. 2 and C.3 of Annex B of the DVB-S2 standard 302.307.

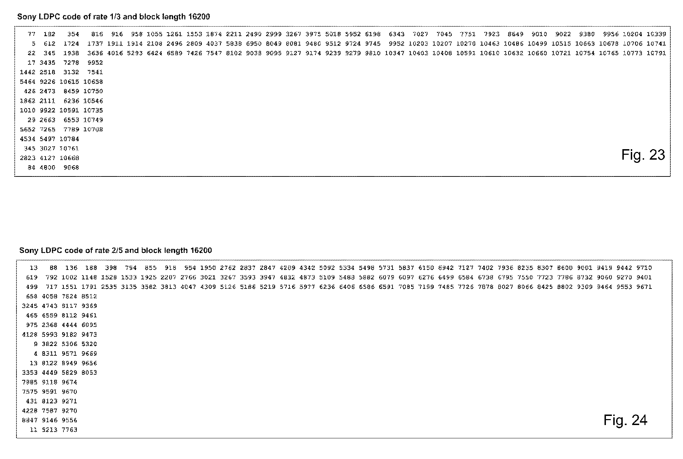

Sony Corporation proposed different LDPC codes for code rates 1/3 and 2/5 as disclosed in the following document available from www.dvb.org, with title "New 16k LDPC codes for DVB-NGH" by Makiko Kan, with filename: "TM-NGH580_NGH_sony_New_16k_Codes.pdf", document-ID TM-H1115 and published 12/12/2010. The particular LDPC codes with code rates 1/3 and 2/5 are depicted respectively in Fig. 23 and 24.

In DVB-T2 mobile there are currently no bit-to-cell DEMUX permutations defined for the code rates 1/3 and 2/5, respectively for 16QAM, 64QAM and 256QAM. As in DVB-T2, QPSK does not need such a permutation, since the two bits encoded in a QPSK constellation have the same robustness level.

In order to maximize the performance of the new LDPC codes of rate 1/3 and 2/5 in conjunction with various QAM constellation sizes and under various reception conditions, new optimized permutation rules are required for the bit-to-cell DEMUX.

### SUMMARY OF THE INVENTION

Therefore, in view of the above problems in the state of the art, one object of the invention is to provide a method for processing of bits of a digital signal, wherein a permutation processing optimizes the performance of the LDPC codes for the different QAM constellation sizes.

The permutation of bits depends on the LDPC code, primarily characterized by its block length and code rate, and on the QAM constellation size. The present invention provides different permutation rules for each combination of LDPC code and QAM constellation. In particular, the LDPC code used may be one of the following, the DVB-S2 standard LDPC code of either 1/3 or 2/5 code rate, or the LDPC code proposed by Sony Corporation of either 1/3 or 2/5 code rate. The relevant QAM constellations are 16QAM, 64QAM and 256QAM.

The present invention according to the set of claims provides permutation rules for the Sony and DVB-S2 LDPC codes of code rate 1/3 for the different QAM constellation sizes, 16QAM, 64QAM and 256QAM, respectively for the transmitting and receiving side.

The above object is solved by the subject matter of the independent claims. Advantageous embodiments of the invention are subject-matters of the dependent claims.

The present invention provides a method for processing a digital signal to be input to a QAM, Quadrature Amplitude Modulation, modulator of the 16QAM type. Bits of the digital signal are encoded according to an LDPC code of the DVB-S2 standard with code rate 2/5 and a block length of 16200 by an encoder. The encoded bits from the encoder are interleaved into an interleaving matrix by an interleaver. The interleaved bits from said interleaver are permuted by a demux before being input to the QAM modulator of the 16QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b6; v1=b5; v2=b2; v3=b7; v4=b4; v5=b3; v6=b0; v7=b1.

The present invention provides a method for processing a digital signal to be input to a QAM, Quadrature Amplitude Modulation, modulator of the 64QAM type. Bits of the digital signal are encoded according to an LDPC code of the DVB-S2 standard with code rate 2/5 and a block length of 16200 by an encoder. The encoded bits from the encoder are interleaved into an interleaving matrix by an interleaver. The interleaved bits from said interleaver are permuted by a demux before being input to the QAM modulator of the 64QAM type, wherein the permuting step is carried out on an 12-bit input word, composed of bits v0, v1, v2, v3, v4, v5, v6, v7, v8, v9, v10 and v1, and generates an 12-bit output word, composed of bits b0, b1, b2, b3, b4, b5, b6, b7, b8, b9, b10 and b11,
wherein v0=b3; v1=b7; v2=b6; v3=b4; v4=b11; v5=b5; v6=b9; v7=b2; v8=b0;
v9=b1; v10=b8; v11=b10.

The present invention provides a method for processing a digital signal to be input to a QAM, Quadrature Amplitude Modulation, modulator of the 256QAM type. Bits of the digital signal are encoded according to an LDPC code of the DVB-S2 standard with code rate 2/5 and a block length of 16200 by an encoder. The encoded bits from the encoder are interleaved into an interleaving matrix by an interleaver. The interleaved bits from said interleaver are permuted by a demux before being input to the QAM modulator of the 256QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b2; v1=b3; v2=b6; v3=b0; v4=b1; v5=b7; v6=b4; v7=b5.

The present invention provides a method for processing a digital signal to be input to a QAM, Quadrature Amplitude Modulation, modulator of the 16QAM type. Bits of the digital signal are encoded according to an LDPC code proposed by Sony Corporation with code rate 2/5 and a block length of 16200 by an encoder. The encoded bits from the encoder are interleaved into an interleaving matrix by an interleaver. The interleaved bits from said interleaver are permuted by a demux before being input to the QAM modulator of the 16QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b4; v1=b7; v2=b6; v3=b2; v4=b3; v5=b1; v6=b0; v7=b5.

The present invention provides a method for processing a digital signal to be input to a QAM, Quadrature Amplitude Modulation, modulator of the 64QAM type. Bits of the digital signal are encoded according to an LDPC code proposed by Sony Corporation with code rate 2/5 and a block length of 16200 by an encoder. The encoded bits from the encoder are interleaved into an interleaving matrix by an interleaver. The interleaved bits from said interleaver are permuted by a demux before being input to the QAM modulator of the 64QAM type, wherein the permuting step is carried out on an 12-bit input word, composed of bits v0, v1, v2, v3, v4, v5, v6, v7, v8, v9, v10 and v1, and generates an 12-bit output word, composed of bits b0, b1, b2, b3, b4, b5, b6, b7, b8, b9, b10 and b11,
wherein v0=b3; v1=b0; v2=b1; v3=b9; v4=b8; v5=b5; v6=b4; v7=b6; v8=b2; v9=b11; v10=b10; v11=b7.

The present invention provides a method for processing a digital signal to be input to a QAM, Quadrature Amplitude Modulation, modulator of the 256QAM type. Bits of the digital signal are encoded according to an LDPC code proposed by Sony Corporation with code rate 2/5 and a block length of 16200 by an encoder. The encoded bits from the encoder are interleaved into an interleaving matrix by an interleaver. The interleaved bits from said interleaver are permuted by a demux before being input to the QAM modulator of the 256QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b3; v1=b2; v2=b7; v3=b0; v4=b4; v5=b1; v6=b5; v7=b6.

The present invention provides a system for transmitting a digital signal, comprising an encoder, an interleaver, a demux and a QAM, Quadrature Amplitude Modulation, modulator, adapted to perform the steps of one of the above mentioned method.

The present invention provides a method for processing a digital signal received and demodulated by a QAM, Quadrature Amplitude Modulation, demodulator of the 16QAM type. The demodulated bits of the digital signal from the QAM demodulator are permuted by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein
v0=b6; v1=b5; v2=b2; v3=b7; v4=b4; v5=b3; v6=b0; v7=b1.

The permuted bits are deinterleaved into a matrix by a deinterleaver. The bits in the matrix are decoded according to an LDPC code of the DVB-S2 standard with code rate 2/5 and a block length of 16200 by a decoder.

The present invention provides a method for processing a digital signal received and demodulated by a QAM, Quadrature Amplitude Modulation, demodulator of the 64QAM type. The demodulated bits of the digital signal from the QAM demodulator are permuted by a multiplexer block, wherein the permuting step is carried out on an 12-bit input word, composed of bits b0, b1, b2, b3, b4, b5, b6, b7, b8, b9, b10 and b11, and generates an 12-bit output word, composed of bits v0, v1, v2, v3, v4, v5, v6, v7, v8, v9, v10 and v11, wherein
v0=b3; v1=b7; v2=b6; v3=b4; v4=b11; v5=b5; v6=b9; v7=b2; v8=b0; v9=b1; v10=b8; v11=b10.

The permuted bits are deinterleaved into a matrix by a deinterleaver. The bits in the matrix are decoded according to an LDPC code of the DVB-S2 standard with code rate 2/5 and a block length of 16200 by a decoder.

The present invention provides a method for processing a digital signal received and demodulated by a QAM, Quadrature Amplitude Modulation, demodulator of the 256QAM type. The demodulated bits of the digital signal from the QAM demodulator are permuted by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein v0=b2; v1=b3; v2=b6; v3=b0; v4=b1; v5=b7; v6=b4; v7=b5.

The permuted bits are deinterleaved into a matrix by a deinterleaver. The bits in the matrix are decoded according to an LDPC code of the DVB-S2 standard with code rate 2/5 and a block length of 16200 by a decoder.

The present invention provides a method for processing a digital signal received and demodulated by a QAM, Quadrature Amplitude Modulation, demodulator of the 16QAM type. The demodulated bits of the digital signal from the QAM demodulator are permuted by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein
v0=b4; v1=b7; v2=b6; v3=b2; v4=b3; v5=b1; v6=b0; v7=b5.

The permuted bits are deinterleaved into a matrix by a deinterleaver. The bits in the matrix are decoded according to an LDPC code proposed by Sony Corporation with code rate 2/5 and a block length of 16200 by a decoder.

The present invention provides a method for processing a digital signal received and demodulated by a QAM, Quadrature Amplitude Modulation, demodulator of the 64QAM type. The demodulated bits of the digital signal from the QAM demodulator are permuted by a multiplexer block, wherein the permuting step is carried out on an 12-bit input word, composed of bits b0, b1, b2, b3, b4, b5, b6, b7, b8, b9, b10 and b11, and generates an 12-bit output word, composed of bits v0, v1, v2, v3, v4, v5, v6, v7, v8, v9, v10 and v11, wherein
v0=b3; v1=b0; v2=b1; v3=b9; v4=b8; v5=b5; v6=b4; v7=b6; v8=b2; v9=b11; v10=b10; v11=b7.

The permuted bits are deinterleaved into a matrix by a deinterleaver. The bits in the matrix are decoded according to an LDPC code proposed by Sony Corporation with code rate 2/5 and a block length of 16200 by a decoder.

The present invention provides a method for processing a digital signal received and demodulated by a QAM, Quadrature Amplitude Modulation, demodulator of the 256QAM type. The demodulated bits of the digital signal from the QAM demodulator are permuted by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein
v0=b3; v1=b2; v2=b7; v3=b0; v4=b4; v5=b1; v6=b5; v7=b6.

The permuted bits are deinterleaved into a matrix by a deinterleaver. The bits in the matrix are decoded according to an LDPC code proposed by Sony Corporation with code rate 2/5 and a block length of 16200 by a decoder.

The present invention provides a system for receiving a digital signal, comprising a QAM, Quadrature Amplitude Modulation, demodulator, a multiplexer block, a deinterleaver and a decoder, adapted to perform the steps of one of the above mentioned methods.

According to an advantageous embodiment of the invention which can be used in addition or alternatively to the above, wherein the QAM modulator performs the 16QAM modulation according to the DVB-T2 standard.

According to an advantageous embodiment of the invention which can be used in addition or alternatively to the above, the bits v0 and b0 are respectively the most significant bits of the 8-bit input word and the 8-bit output word, and the bits v7 and b7 are respectively the least significant bits of the 8-bit input word and 8-bit output word.

According to an advantageous embodiment of the invention which can be used in addition or alternatively to the above, wherein the step of interleaving comprises the step of parity interleaving and column twist interleaving, generating the interleaving matrix with 8 columns and 2025 rows.

According to an advantageous embodiment of the invention which can be used in addition or alternatively to the above, wherein bits b0, b1, b2 and b3 constitute a first cell word and bits b4, b5, b6 and b7 constitute a second cell word, each cell word being mapped to one modulation symbol by the QAM modulator of the 16QAM type.

### BRIEF DESCRIPTION OF THE FIGURES

In the following the invention is described in more detail with reference to the attached figures and drawings.
- **Fig. 1**: shows a system overview of the DVB-T2 modulator,
- **Fig. 2**: shows the LDPC codeword, composed of the baseband frame, the BCH parity part and the LDPC parity part,
- **Fig. 3**: is an abstract block diagram for the BICM encoder including the various relevant subsystems for processing data,
- **Fig. 4**: illustrates the working principle if a column-row bit interleaver with column-twisting according to the DVB-T2 standard,
- **Fig. 5, 6**: respectively disclose the column-row interleaver with 8 and 12 columns for LDPC block of length 16200,
- **Fig. 7**: is a diagram illustrating the input and output of the bit-to-cell DEMUX in the BICM encoder in a transmitter according to an embodiment of the invention,

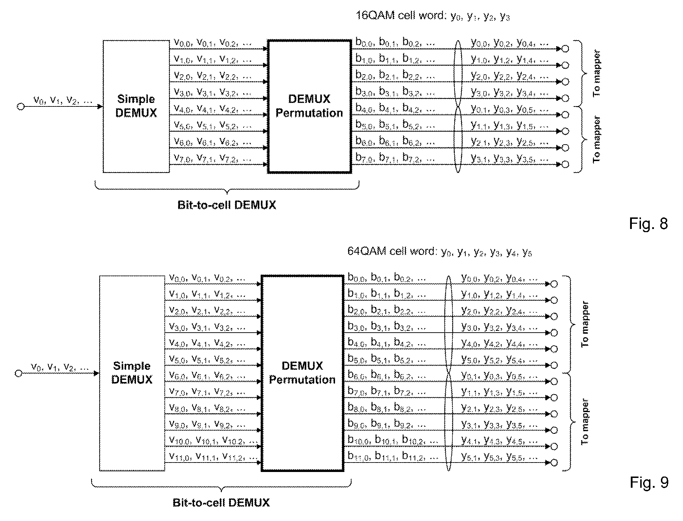

- **Fig. 8-10**: illustrate the bit-to-cell DEMUX block, composed of the simple demultiplexing processing and the permutation processing, respectively for the case of 16QAM, 64QAM and 256QAM,
- **Fig. 11-14**: show the particular constellation mappings respectively for QPSK, 16QAM, 64QAM and 256QAM applicable in DVB-T2 for transmission and reception of data,

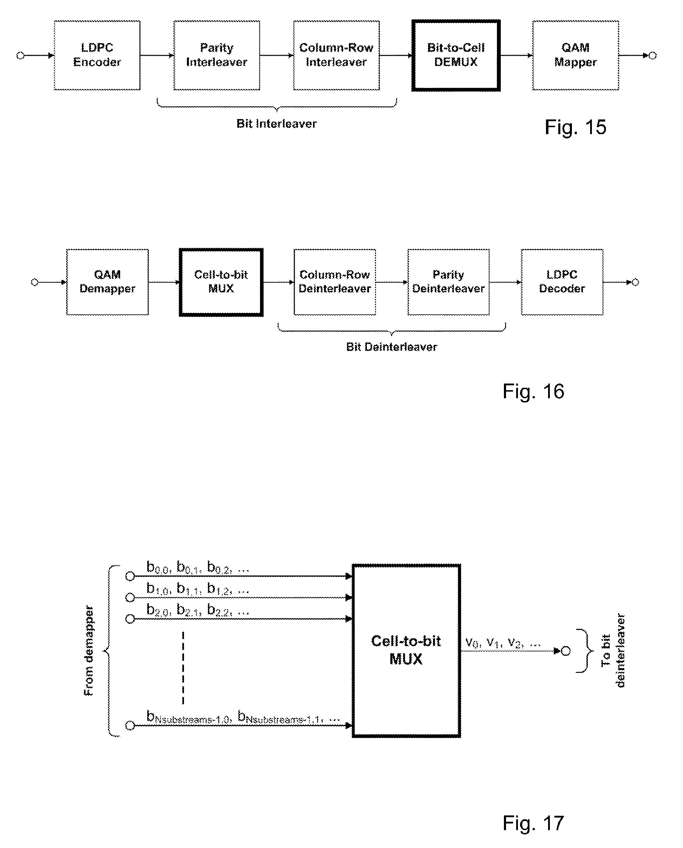

- **Fig. 15**: shows the BICM encoder for a transmitting side according to an embodiment of the invention,
- **Fig. 16**: shows the BICM decoder for a receiving side according to an embodiment of the invention,
- **Fig. 17**: shows the input and output of the cell-to-bit MUX of the BICM decoder in a receiver according to an embodiment of the invention,

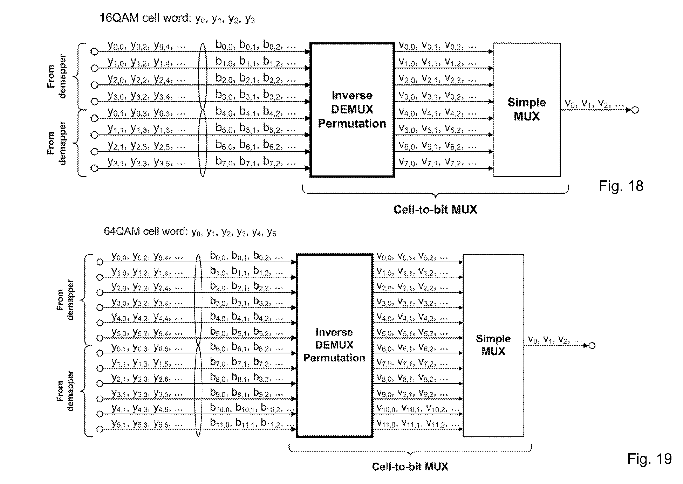

- **Fig. 18-20**: illustrate the cell-to-bit MUX block, composed of the simple multiplexing processing and the permutation processing, being inverse to the permutation of the DEMUX in the transmitter side, respectively for 16QAM, 64QAM and 256 QAM,

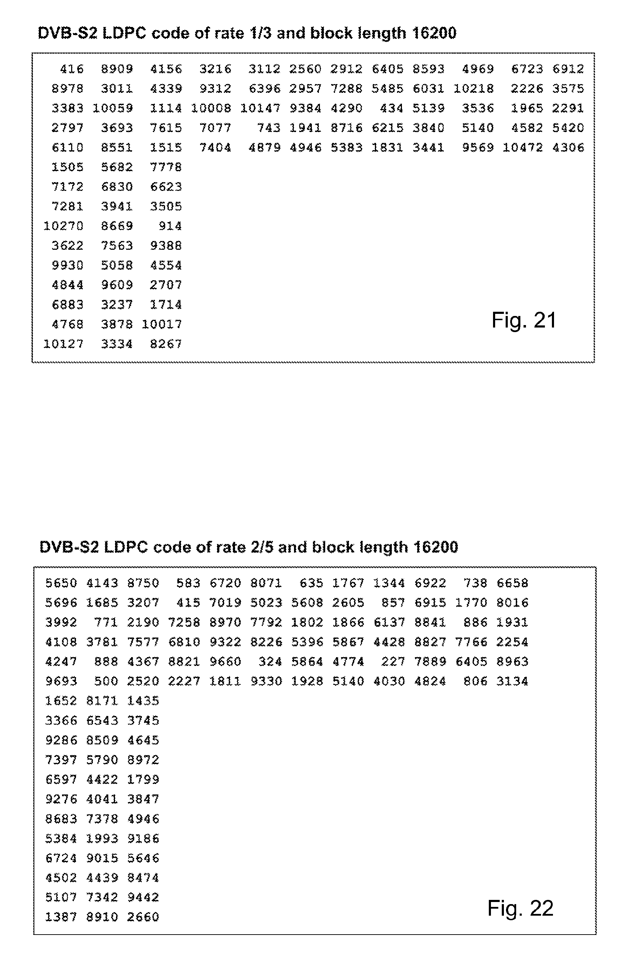

- **Fig. 21**: shows the DVB-S2 LDPC code for block length=16200 and code rate 1/3,
- **Fig. 22**: shows the DVB-S2 LDPC code for block length=16200 and code rate 2/5,
- **Fig. 23**: shows the Sony LDPC code for block length=16200 and code rate 1/3, and
- **Fig. 24**: shows the Sony LDPC code for block length=16200 and code rate 2/5.

### Detailed Description

In the following, several embodiments of the invention will be explained in detail. The explanations should not be understood as limiting the invention, but as a mere example of the general principles of the invention. A skilled person should be aware that the general principles of the invention as laid out in the claims can be applied to different scenarios and in ways that are not explicitly described herein.

Though most of the embodiments of the invention explained in the following will refer to the DVB-T2 mobile subset system, this should not restrict the scope of protection. Actually, the embodiments of the present invention can be applied to any system having the structural features as explained in the independent claims.

For instance, a new DVB-NGH standard will update and replace the DVB-H standard for digital broadcasting to mobile devices. However, the exact BICM structure used for DVB-NGH is not yet decided. In case the DVB-NGH standard adopts a structure similar to the DVB-T2 mobile subset system, it is also possible to apply the principles of the present invention to the DVB-NGH standard.

### Transmitting Side

Various embodiments of the invention provide a system for processing bit signals before they are input to a modulator for being transmitted. Further embodiments of the invention relate to the inverse process of receiving signals which are demodulated into bit streams and are then processed to arrive at an information signal.

It is assumed that a digital signal, comprising e.g. an audio and/or video signal, is to be transmitted/broadcast and is intended to be received by mobile terminals.

A general overview of the system used in the various embodiments of the invention is presented in Fig. 12, and basically corresponds to that of the DVB-T2 standard explained in great detail in the background section with reference to Fig. 1-11.

In particular, a digital signal, such as an audio and/or a video signal, consisting of information bits is input to the LDPC encoder and encoded by the LDPC encoder block according to the DVB-S2 16200 LDPC code or the Sony 16200 LDPC code using a code rate of 1/3 and 2/5.

The DVB-S2 16200 LDPC codes with coding rate of 1/3 and 2/5 used in the LDPC encoder of this embodiment of the invention are respectively depicted in Fig. 21 and 22 (according to EN 302.307, v1.2.1 Tables C.2 and C,3 of Annex C).

The Sony 16200 LDPC code for code rate 1/3 used in the LDPC encoder of another embodiment of the invention is depicted in Fig. 23, and the Sony 16200 LDPC code for code rate 2/5 used in the LDPC encoder of another embodiment of the invention is depicted in Fig. 24.

The LDPC encoder outputs a stream of data packets consisting of N_{LDPC}=16200 bits. It should be noted that an encoder output of 64800 bits for packet streams is not foreseen for transmission/reception of signals for handheld devices. The encoded 16200 bit LDPC blocks are input to a column-row interleaver block that performs parity interleaving and column-twist interleaving as explained in the background section and in accordance with the DVB-T2 standard, Chapter 6.1.3, incorporated herein by reference.

Depending on the type of modulation which is being used in the later constellation mapping block, the interleaving block generates a bit matrix out of the encoded 16200 packet bits with different dimensions. As previously explained, for 16QAM and N_{LDPC}=16200 the number of rows Nᵣ= 2025 and the number of columns N_{c}= 8. For 64QAM and N_{LDPC}=16200 the number of rows Nᵣ= 1350 and the number of columns N_{c}= 12. For 256QAM and N_{LDPC}=16200 the number of rows Nᵣ= 2025 and the number of columns N_{c}= 8.The 16200 data bits output from the parity interleaver are serially written column-wise, as illustrated in Fig. 4, 5 or 6. Column twisting parameters t_{c} can be used for defining the write start position, when using the DVB-S2 16200 LDPC code or Sony 16200 LDPC code in the LDPC encoder, as previously explained.

It should be noted however, that the embodiments of the invention, in particular the various permutation rules, can be applied to all column twisting parameters. Furthermore, though column twist interleaving is part of the DVB-T2 system, and thus will be part of the DVB-T2 mobile subset system, the embodiments of the present invention can also be applied to a bit interleaving process without column twist.

After the column-twist processing, the 16200-bit LDPC blocks are to be permuted according to the different embodiments of the invention. The permutation processing, and in particular the permutation rules which are to be applied depend on:
- the LDPC code used, further characterized by its block length and the code rate, and on
- the QAM constellation size.

As explained before, the input bits of the LDPC block are demultiplexed into parallel cell words, then the permutation is performed after which the permuted cell words are mapped into constellation symbols according to the specified QAM mapping. The number of output QAM data cells (cell words) and the effective number of bits per cell word η_{MOD} is the same as for DVB-T2. Particularly, there are 8100 cells for QPSK, 4050 cells for, 2700 cells for 64QAM, and 2025 cells for 256 QAM.

The bit stream from the bit interleaver is demultiplexed into substreams as shown in Fig. 7, wherein the number of substreams is the same as for DVB-T2; in particular, two for QPSK constellations, 8 for 16QAM, 12 for 64QAM and 8 for 256QAM.

After the demultiplexing operation of the bit-to-cell DEMUX a permutation is performed by a particular interleaving of input bits v_{di} onto the output bits b_{e,do}, where:
- do = di div N_{substreams};
- e is the de-multiplexed bit substream number (0 ≤ e < N_{substreams});
- v_{di} is the input to the de-multiplexer;
- di is the input bit number;
- b_{e,do} is the output from the de-multiplexer;
- do is the bit number of a given stream at the output of the de-multiplexer.

Fig. 8 illustrates the bit-to-cell DEMUX, and in particular the demultiplexing block and the permutation block of which it consists, and shows the inputs and outputs of the bit-to-cell DEMUX. Fig. 8 specifically refers to the case of 16QAM for which N_{subtreams}=8, where each substream has 16200/8=2025 bits (do = di div N_{substreams}). As apparent from Fig. 8, the output bits b₀₋₇ include 2 cell words (y₀₋₃) that are then forwarded to the 16QAM modulator.

Fig. 9 illustrates the bit-to-cell DEMUX for the 64QAM modulation, where N_{subtreams}=12, and each substream has 16200/12=1350 bits. As apparent from Fig. 9, the output bits b₀₋₁₁ include 2 cell words (y₀₋₅), that are then forwarded to the 64QAM modulator.

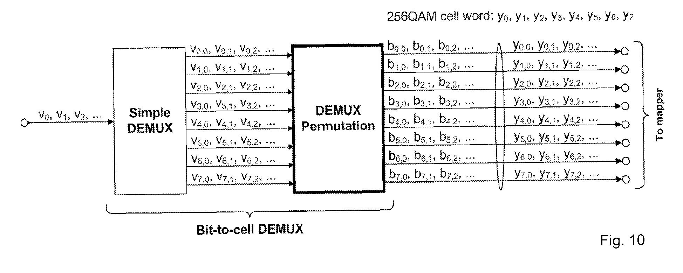

Fig. 10 illustrates the bit-to-cell DEMUX for the 256QAM modulation, where N_{subtreams}=8, and each substream has 16200/8=2025 bits. As apparent from Fig. 10, the output bits b0-7 include one cell word y0-7 that is forwarded to the 256QAM modulator.

The resulting cell words are serially output to the constellation mapper. The QAM modulation modes will be implemented in the constellation mapper block of Fig. 15, which maps the cell words (output from the bit-to-cell demultiplexer block) to the constellation symbols according to the particular 16, 64 and 256QAM modulation of Fig. 12, 13 and 14, i.e. according to the bit labelling used in the DVB-T2 standard.

In the following, demultiplexing parameters will be presented according to various embodiments of the invention for applying permutation schemes for code rate 1/3 and different modulation modes and different LDPC codes. The following permutation is applied in the permutation sub-block of cell-to-bit DEMUX, according to Fig. 8-10.

### DVB-S2 16200 LDPC code of rate 1/3 & 16QAM

According to one embodiment, the LDPC encoder uses the DVB-S2 16200 LDPC code of rate 1/3 as presented above, and a 16QAM modulator is used as constellation mapper. The permutation in the DEMUX block is performed as depicted in Fig. 8 on the 8 bits of a row of the FECframe matrix that is read out row-wise and then demultiplexed according to Fig. 8.

After the demultiplexing process, the 8 input bits v_{di} are permuted to the 8 output bits be according to the following rule:
v0=b3; v1=b6; v2=b7; v3=b2; v4=b1; v5=b5; v6=b4; v7=b0;

After performing the above permutation the two cell words are extracted for each be , and the two bit cell words y₀₋₃ are output to the constellation mapper of the 16QAM type for being mapped to two consecutive modulation symbols.

### DVB-S2 16200 LDPC code of rate 1/3 & 64QAM

According to another embodiment, the LDPC encoder uses the DVB-S2 16200 LDPC code of rate 1/3 as presented above, and a 64QAM modulation is used in the constellation mapper. The permutation in the DEMUX block is performed as depicted in Fig. 9 on the 12 bits of a row of the FECframe matrix that is read out row-wise and then demultiplexed according to Fig. 9.

After the demultiplexing process, the 12 input bits v_{di} are permuted to the 12 output bits be according to the following rule:
v0=b3; v1=b11; v2=b4; v3=b10; v4=b9; v5=b7; v6=b1; v7=b8; v8=b6; v9=b0; v10=b2; v11=b5;

After performing the above permutation the two cell words are extracted for each be, and the two bit cell words y₀₋₅ are output to the constellation mapper of the 64QAM type for being mapped to two consecutive modulation symbols.

### DVB-S2 16200 LDPC code of rate 1/3 & 256QAM

According to another embodiment, the LDPC encoder uses the DVB-S2 16200 LDPC code of rate 1/3 as presented above, and a 256QAM modulation is used in the constellation mapper. The permutation in the DEMUX block is performed as depicted in Fig. 10 on the 8 bits of a row of the FECframe matrix that is read out row-wise and then demultiplexed according to Fig. 10.

After the demultiplexing process, the 8 input bits v_{di} are permuted to the 8 output bits be according to the following rule:
v0=b7; v1=b6; v2=b1; v3=b5; v4=b4; v5=b3; v6=b0; v7=b2;

After performing the above permutation the one cell word is extracted for each be, and the bit cell word y₀₋₇ is output to the constellation mapper of the 256QAM type for being mapped to a consecutive modulation symbol.

### Sony 16200 LDPC code of rate 1/3 & 16QAM

According to one embodiment, the LDPC encoder uses the Sony 16200 LDPC code of rate 1/3 as presented above, and a 16QAM modulator is used as constellation mapper. The permutation in the DEMUX block is performed as depicted in Fig. 8 on the 8 bits of a row of the FECframe matrix that is read out row-wise and then demultiplexed according to Fig. 8.

After the demultiplexing process, the 8 input bits v_{di} are permuted to the 8 output bits be according to the following rule:
v0=b7; v1=b0; v2=b1; v3=b6; v4=b4; v5=b5; v6=b3; v7=b2;

After performing the above permutation the two cell words are extracted for each be, and the two bit cell words y₀₋₃ are output to the constellation mapper of the 16QAM type for being mapped to two consecutive modulation symbols.

### Sony 16200 LDPC code of rate 1/3 & 64QAM

According to another embodiment, the LDPC encoder uses the Sony 16200 LDPC code of rate 1/3 as presented above, and a 64QAM modulation is used in the constellation mapper. The permutation in the DEMUX block is performed as depicted on Fig. 9 on the 12 bits of a row of the FECframe matrix that is read out row-wise and then demultiplexed according to Fig. 9.

After the demultiplexing process, the 12 input bits v_{di} are permuted to the 12 output bits be according to the following rule:
v0=b6; v1=b10; v2=b11; v3=b5; v4=b7; v5=b3; v6=b4; v7=b9; v8=b1; v9=b8; v10=b2; v11=b0;

After performing the above permutation the two cell words are extracted for each be, and the two bit cell words y₀₋₅ are output to the constellation mapper of the 64QAM type for being mapped to two consecutive modulation symbols.

### Sony 16200 LDPC code of rate 1/3 & 256QAM

According to another embodiment, the LDPC encoder uses the Sony 16200 LDPC code of rate 1/3 as presented above, and a 256QAM modulation is used in the constellation mapper. The permutation in the DEMUX block is performed as depicted in Fig. 10 on the 8 bits of a row of the FECframe matrix that is read out row-wise and then demultiplexed according to Fig. 10.

After the demultiplexing process, the 8 input bits v_{di} are permuted to the 8 output bits be according to the following rule:
v0=b0; v1=b6; v2=b7; v3=b1; v4=b2; v5=b3; v6=b4; v7=b5;

After performing the above permutation the one cell word is extracted for each be, and the bit cell word y₀₋₇ is output to the constellation mapper of the 256QAM type for being mapped to a consecutive modulation symbol.

In the following, demultiplexing parameters will be presented according to various embodiments of the invention for applying permutation schemes for code rate 2/5 and different modulation modes and different LDPC codes.

### DVB-S2 16200 LDPC code of rate 2/5 & 16QAM

According to one embodiment, the LDPC encoder uses the DVB-S2 16200 LDPC code of rate 2/5 as presented above, and a 16QAM modulator is used as constellation mapper. The permutation in the DEMUX block is performed as depicted in Fig. 8 on the 8 bits of a row of the FECframe matrix that is read out row-wise and then demultiplexed according to Fig. 8.

After the demultiplexing process, the 8 input bits v_{di} are permuted to the 8 output bits be according to the following rule:
v0=b6; v1=b5; v2=b2; v3=b7; v4=b4; v5=b3; v6=b0; v7=b1;

After performing the above permutation the two cell words are extracted for each be, and the two bit cell words y₀₋₃ are output to the constellation mapper of the 16QAM type for being mapped to two consecutive modulation symbols.

### DVB-S2 16200 LDPC code of rate 2/5 & 64QAM

According to another embodiment, the LDPC encoder uses the DVB-S2 16200 LDPC code of rate 2/5 as presented above, and a 64QAM modulation is used in the constellation mapper. The permutation in the DEMUX block is performed as depicted in Fig. 9 on the 12 bits of a row of the FECframe matrix, that are readout row-wise and then demultiplexed according to Fig. 9.

After the demultiplexing process, the 12 input bits v_{di} are permuted to the 12 output bits be according to the following rule:
v0=b3; v1=b7; v2=b6; v3=b4; v4=b11; v5=b5; v6=b9; v7=b2; v8=b0; v9=b1; v10=b8; v11=b10;

After performing the above permutation the two cell words are extracted for each be, and the two bit cell words y₀₋₅ are output to the constellation mapper of the 64QAM type for being mapped to two consecutive modulation symbols.

### DVB-S2 16200 LDPC code of rate 2/5 & 256QAM

According to another embodiment, the LDPC encoder uses the DVB-S2 16200 LDPC code of rate 2/5 as presented above, and a 256QAM modulation is used in the constellation mapper. The permutation in the DEMUX block is performed as depicted in Fig. 10 on the 8 bits of a row of the FECframe matrix that is read out row-wise and then demultiplexed according to Fig. 10.

After the demultiplexing process, the 8 input bits v_{di} are permuted to the 8 output bits be according to the following rule:
v0=b2; v1=b3; v2=b6; v3=b0; v4=b1; v5=b7; v6=b4; v7=b5;

After performing the above permutation the one cell word is extracted for each be, and the bit cell word y₀₋₇ is output to the constellation mapper of the 256QAM type for being mapped to a consecutive modulation symbol.

### Sony 16200 LDPC code of rate 2/5 & 16QAM

According to one embodiment, the LDPC encoder uses the Sony 16200 LDPC code of rate 2/5 as presented above, and a 16QAM modulator is used as constellation mapper. The permutation in the DEMUX block is performed as depicted on Fig. 8 on the 8 bits of a row of the FECframe matrix that is read out row-wise and then demultiplexed according to Fig. 8.

After the demultiplexing process, the 8 input bits v_{di} are permuted to the 8 output bits be according to the following rule:
v0=b4; v1=b7; v2=b6; v3=b2; v4=b3; v5=b1; v6=b0; v7=b5;

After performing the above permutation the two cell words are extracted for each be, and the two bit cell words y₀₋₃ are output to the constellation mapper of the 16QAM type for being mapped to two consecutive modulation symbols.

### Sony 16200 LDPC code of rate 2/5 & 64QAM

According to another embodiment, the LDPC encoder uses the Sony 16200 LDPC code of rate 2/5 as presented above, and a 64QAM modulation is used in the constellation mapper. The permutation in the DEMUX block is performed as depicted on Fig. 9 on the 12 bits of a row of the FECframe matrix that is read out row-wise and then demultiplexed according to Fig. 9.

After the demultiplexing process, the 12 input bits v_{di} are permuted to the 12 output bits be according to the following rule:
v0=b3; v1=b0; v2=b1; v3=b9; v4=b8; v5=b5; v6=b4; v7=b6; v8=b2; v9=b11; v10=b10; v11=b7;

After performing the above permutation the two cell words are extracted for each be, and the two bit cell words y₀₋₅ are output to the constellation mapper of the 64QAM type for being mapped to two consecutive modulation symbols.

### Sony 16200 LDPC code of rate 2/5 & 256QAM

According to another embodiment, the LDPC encoder uses the Sony 16200 LDPC code of rate 2/5 as presented above, and a 256QAM modulation is used in the constellation mapper. The permutation in the DEMUX block is performed as depicted in Fig. 10 on the 8 bits of a row of the FECframe matrix that is read out row-wise and then demultiplexed according to Fig. 10.

After the demultiplexing process, the 8 input bits v_{di} are permuted to the 8 output bits be according to the following rule:
v0=b3; v1=b2; v2=b7; v3=b0; v4=b4; v5=b1; v6=b5; v7=b6;

After performing the above permutation the one cell word is extracted for each be, and the bit cell word y₀₋₅ is output to the constellation mapper of the 256QAM type for being mapped to a consecutive modulation symbol.

### Receiving Side

The previously explained embodiments refer to the transmitting side for transmitting information signals to e.g. mobile terminals. In the following, embodiments of the invention will be provided referring to the receiving side, and thus refers to apparatuses such as handheld devices, mobile phones, tablet PCs, notebooks, televisions, etc.

The processing in the receiving side will basically be the reverse of the above-explained processing on the transmission side. In summary, complex cells will be demodulated according to the constellation mapping (QPSK, 16QAM, 64QAM, 256QAM) to determine the transmitted bit cell words. One cell word (256QAM) or two cell words (16QAM and 64QAM) will be bit-permuted according to a permutation rule being inverse to that in the transmitting side, and then multiplexed into a bit stream. The resulting bit stream is further deinterleaved by a column-row matrix deinterleaver, as well as by a a parity de-interleaver, which deinterleaves the LDPC parity bits only. The parity de-interleaver outputs a stream of encoded bits that are decoded by the LDPC-decoder block for the DVB-S2 or Sony code, in concordance with the transmitting side LDPC coding.

This will be presented in more detail below.

Fig. 16 shows a general structure for the receiving side according to an embodiment of the invention. In particular, a QAM demapper block demodulates a complex cells according to a particular modulation mode such as 16QAM, 64QAM or 256QAM and outputs cell words comprising respectively 4, 6 or 8 bits to the cell-to-bit MUX (multiplexer) block.

The QAM demodulation performed in the demodulation block should be in accordance with the one of the transmitting side. If on the transmitting side a 16QAM according to the DVB-T2 labelling of Fig. 12 is performed, the demodulation should be based on the same 16QAM of Fig. 12, to demodulate each modulation symbol into a cell word of 4 bits. The same applies to the all the QAM modulations according to Fig. 12-14.

The cell-to-bit multiplexer block comprises a permutation block and a multiplexing block. The permutation block processes the demodulated bits according to a permutation rule depending on the modulation mode and the LDPC code used in the transmitting side (and conversely in the receiving side).

As apparent from Fig. 17 which shows the generic bit processing in the cell-to-bit MUX, cell words y, constitute the input bits b to the permutation block, and are permuted to generate output words v. The output of the permutation block is multiplexed to one stream of bits v.

Fig. 18, 19 and 20 show the bit processing in the cell-to-bit MUX for respectively the 16QAM, 64QAM and 256 QAM.

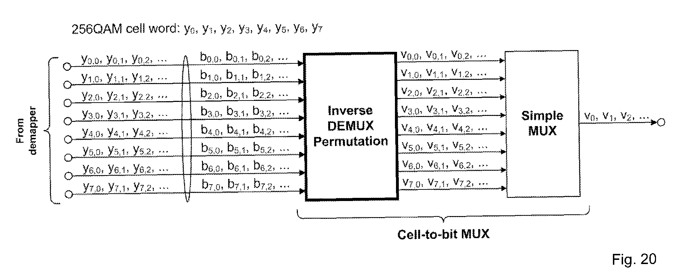

In particular, according to Fig. 18, a 16QAM demodulator outputs cell words of 4 bits y₀₋₃, two of which are grouped to bit blocks b₀₋₇, on which the permutation is then performed to generate the bit sequence v₀₋₇. According to Fig. 19, a 64QAM demodulator outputs cell words of 6 bits y₀₋₅, two of which are grouped to form bit blocks b₀₋₁₁, on which the permutation is then performed to generate the bit sequence v₀₋₁₁. According to Fig. 20, a 256QAM demodulator outputs cell words of 8 bits y₀₋₇, which form the bit blocks b₀₋₇, on which the permutation is then performed to generate the bit sequence v₀₋₇.

The different permutation rules to be applied in this processing of the cell-to-bit MUX will be explained in more detail later.

The number of substreams is 8 for 16QAM, 12 for 64QAM and 8 for 256QAM.

The multiplexer block of the cell-to-bit MUX multiplexes the permuted bits v of the substreams to a single bit-stream of 16200 bits.

The resulting bit stream, comprising the bits v, is input to the column-row deinterleaver, which writes the bits v row wise into a deinterleaver matrix. The dimensions of the matrix depend on the constellation size used. In more detail, for 16QAM the number of columns is 8, resulting in 2025 rows. For 64QAM the number of columns is 12, resulting in 1350 rows. For 256QAM the number of columns is 8, resulting in 2025 rows. The deinterleaver matrix is read out column-wise.

Prior to the LDPC decoding, the additional parity de-interleaving step is performed, in which the LDPC parity bits are deinterleaved.

The LDPC decoder decodes the bits using the DVB-S2 or Sony 16200 LDPC code with the corresponding code rate of 1/3 or 2/5, in concordance with the encoding used in the transmitting side.

In the following, permutation parameters will be presented according to various embodiments of the invention, which are to be applied by the corresponding permutation block of the cell-to-bit MUX according to Fig. 17-20.

### DVB-S2 16200 LDPC code of rate 1/3 & 16QAM

According to this embodiment of the invention, the LDPC encoder/decoder uses the DVB-S2 16200 LDPC code of code rate 1/3 as discussed above, and a 16QAM demodulator is used as the QAM demapper. The permutation is performed in the cell-to-bit MUX according to Fig. 18 on 8 bits that are input sequentially by the QAM demapper.

In the permutation process, the 8 input bits be of two cell words are permuted to 8 output bits v_{di}, according to the following rule:
v0=b3; v1=b6; v2=b7; v3=b2; v4=b1; v5=b5; v6=b4; v7=b0;

The thus permuted bits v are then multiplexed by the multiplexing block of the cell-to-bit multiplexer.

### DVB-S2 16200 LDPC code of rate 1/3 & 64QAM

According to this embodiment of the invention, the LDPC encoder/decoder uses the DVB-S2 16200 LDPC code of rate 1/3 as discussed above, and a 64QAM demodulator is used as the QAM demapper. The permutation is performed in the cell-to-bit MUX according to Fig. 19 on 12 bits that are input sequentially by the QAM demapper.

In the permutation process, the 12 input bits be of two cell words are permuted to 12 output bits v_{di}, according to the following rule:
v0=b3; v1=b11; v2=b4; v3=b10; v4=b9; v5=b7; v6=b1; v7=b8; v8=b6; v9=b0; v10=b2; v11=b5;

The thus permuted bits v are then multiplexed by the multiplexing block of the cell-to-bit multiplexer.

### DVB-S2 16200 LDPC code of rate 1/3 & 256QAM

According to this embodiment of the invention, the LDPC encoder/decoder uses the DVB-S2 16200 LDPC code of rate 1/3 as discussed above, and a 256QAM demodulator is used as the QAM demapper. The permutation is performed in the cell-to-bit MUX according to Fig. 20 on 8 bits that are input sequentially by the QAM demapper.

In the permutation process, the 8 input bits be of one cell word are permuted to 8 output bits v_{di}, according to the following rule:
v0=b7; v1=b6; v2=b1; v3=b5; v4=b4; v5=b3; v6=b0; v7=b2;

The thus permuted bits v are then multiplexed by the multiplexing block of the cell-to-bit multiplexer.

### Sony 16200 LDPC code of rate 1/3 & 16QAM

According to this embodiment of the invention, the LDPC encoder/decoder uses the Sony 16200 LDPC code of rate 1/3 as discussed above, and a 16QAM demodulator is used as the QAM demapper. The permutation is performed in the cell-to-bit MUX according to Fig. 18 on 8 bits that are input sequentially by the QAM demapper.

In the permutation process, the 8 input bits be of two cell words are permuted to 8 output bits v_{di}, according to the following rule:
v0=b7; v1=b0; v2=b1; v3=b6; v4=b4; v5=b5; v6=b3; v7=b2;

The thus permuted bits v are then multiplexed by the multiplexing block of the cell-to-bit multiplexer.

### Sony 16200 LDPC code of rate 1/3 & 64QAM

According to this embodiment of the invention, the LDPC encoder/decoder uses the Sony 16200 LDPC code of rate 1/3 as discussed above, and a 64QAM demodulator is used as the QAM demapper. The permutation is performed in the cell-to-bit MUX according to Fig. 19 on 12 bits that are input sequentially by the QAM demapper.

In the permutation process, the 12 input bits be of two cell words are permuted to 12 output bits v_{di}, according to the following rule:
v0=b6; v1=b10; v2=b11; v3=b5; v4=b7; v5=b3; v6=b4; v7=b9; v8=b1; v9=b8; v10=b2; v11=b0;

The thus permuted bits v are then multiplexed by the multiplexing block of the cell-to-bit multiplexer.

### Sony 16200 LDPC code of rate 1/3 & 256QAM

According to this embodiment of the invention, the LDPC encoder/decoder uses the Sony 16200 LDPC code of rate 1/3 as discussed above, and a 256QAM demodulator is used as the QAM demapper. The permutation is performed in the cell-to-bit MUX according to Fig. 20 on 8 bits that are input sequentially by the QAM demapper.

In the permutation process, the 8 input bits be of one cell word are permuted to 8 output bits v_{di}, according to the following rule:
v0=b0; v1=b6; v2=b7; v3=b1; v4=b2; v5=b3; v6=b4; v7=b5;

The thus permuted bits v are then multiplexed by the multiplexing block of the cell-to-bit multiplexer.

In the following, with respect to the cell-to-bit MUX, multiplexing parameters will be presented according to various embodiments of the invention for applying permutation schemes for code rate 2/5 and different modulation modes and different LDPC codes.

### DVB-S2 16200 LDPC code of rate 2/5 & 16QAM

According to this embodiment of the invention, the LDPC encoder/decoder uses the DVB-S2 16200 LDPC code of rate 2/5 as discussed above, and a 16QAM demodulator is used as the QAM demapper. The permutation is performed in the cell-to-bit MUX according to Fig. 18 on 8 bits that are input sequentially by the QAM demapper.

In the permutation process, the 8 input bits be of two cell words are permuted to 8 output bits v_{di}, according to the following rule:
v0=b6; v1=b5; v2=b2; v3=b7; v4=b4; v5=b3; v6=b0; v7=b1;

The thus permuted bits v are then multiplexed by the multiplexing block of the cell-to-bit multiplexer.

### DVB-S2 16200 LDPC code of rate 2/5 & 64QAM

According to this embodiment of the invention, the LDPC encoder/decoder uses the DVB-S2 16200 LDPC code of rate 2/5 as discussed above, and a 64QAM demodulator is used as the QAM demapper. The permutation is performed in the cell-to-bit MUX according to Fig. 19 on 12 bits that are input sequentially by the QAM demapper.

In the permutation process, the 12 input bits be of two cell words are permuted to 12 output bits v_{di}, according to the following rule:
v0=b3; v1=b7; v2=b6; v3=b4; v4=b11; v5=b5; v6=b9; v7=b2; v8=b0; v9=b1; v10=b8; v11=b10;

The thus permuted bits v are then multiplexed by the multiplexing block of the cell-to-bit multiplexer.

### DVB-S2 16200 LDPC code of rate 2/5 & 256QAM

According to this embodiment of the invention, the LDPC encoder/decoder uses the DVB-S2 16200 LDPC code of rate 2/5 as discussed above, and a 256QAM demodulator is used as the QAM demapper. The permutation is performed in the cell-to-bit MUX according to Fig. 20 on 8 bits that are input sequentially by the QAM demapper.

In the permutation process, the 8 input bits be of one cell word are permuted to 8 output bits v_{di}, according to the following rule:
v0=b2; v1=b3; v2=b6; v3=b0; v4=b1; v5=b7; v6=b4; v7=b5;

The thus permuted bits v are then multiplexed by the multiplexing block of the cell-to-bit multiplexer.

### Sony 16200 LDPC code of rate 2/5 & 16QAM

According to this embodiment of the invention, the LDPC encoder/decoder uses the Sony 16200 LDPC code of rate 2/5 as discussed above, and a 16QAM demodulator is used as the QAM demapper. The permutation is performed in the cell-to-bit MUX according to Fig. 18 on 8 bits that are input sequentially by the QAM demapper.

In the permutation process, the 8 input bits be of two cell words are permuted to 8 output bits v_{di}, according to the following rule:
v0=b4; v1=b7; v2=b6; v3=b2; v4=b3; v5=b1; v6=b0; v7=b5;

The thus permuted bits v are then multiplexed by the multiplexing block of the cell-to-bit multiplexer.

### Sony 16200 LDPC code of rate 2/5 & 64QAM

According to this embodiment of the invention, the LDPC encoder/decoder uses the Sony 16200 LDPC code of rate 2/5 as discussed above, and a 64QAM demodulator is used as the QAM demapper. The permutation is performed in the cell-to-bit MUX according to Fig. 19 on 12 bits that are input sequentially by the QAM demapper.

In the permutation process, the 12 input bits be of two cell words are permuted to 12 output bits v_{di}, according to the following rule:
v0=b3; v1=b0; v2=b1; v3=b9; v4=b8; v5=b5; v6=b4; v7=b6; v8=b2; v9=b11; v10=b10; v11=b7;

The thus permuted bits v are then multiplexed by the multiplexing block of the cell-to-bit multiplexer.

### Sony 16200 LDPC code of rate 2/5 & 256QAM

According to this embodiment of the invention, the LDPC encoder/decoder uses the Sony 16200 LDPC code of rate 2/5 as discussed above, and a 256QAM demodulator is used as the QAM demapper. The permutation is performed in the cell-to-bit MUX according to Fig. 20 on 8 bits that are input sequentially by the QAM demapper.

In the permutation process, the 8 input bits be of one cell word are permuted to 8 output bits v_{dl}, according to the following rule:
v0=b3; v1=b2; v2=b7; v3=b0; v4=b4; v5=b1; v6=b5; v7=b6;

The thus permuted bits v are then multiplexed by the multiplexing block of the cell-to-bit multiplexer.

The following tables give an overview over the proposed permutation rules for the above-explained embodiments of the invention.

| **Modulation** | **DVB-S2 16K LDPC codes** | |
|---|---|---|
| | **CR 1/3** | **CR 2/5** |
| 16QAM | [3 6 7 2 1 5 4 0] | [6 5 2 7 4 3 0 1] |
| 64QAM | [3 11 4 10 9 7 1 8 6 0 2 5] | [3 7 6 4 11 5 9 2 0 1 8 10] |
| 256QAM | [7 6 1 5 4 3 0 2] | [2 3 6 0 1 7 4 5] |

| **Modulation** | **Sony 16K LDPC codes** | |
|---|---|---|
| | CR 1/3 | CR 2/5 |
| 16QAM | [7 0 1 6 4 5 3 2] | [4 7 6 2 3 1 0 5] |
| 64QAM | [6 10 11 5 7 3 4 9 1 8 2 0] | [3 0 1 9 8 5 4 6 2 11 10 7] |
| 256QAM | [0 6 7 1 2 3 4 5] | [3 2 7 0 4 1 5 6] |

The explanations given in the Technical Background section above are intended to better understand the specific exemplary embodiments described herein and should not be understood as limiting the invention to the described specific implementations of processes and functions in the mobile communication network. Nevertheless, the improvements proposed herein may be readily applied in the architectures/systems described in the Technological Background section and may in some embodiments of the invention also make use of standard and improved procedures of theses architectures/systems. It would be appreciated by a person skilled in the art that numerous variations and/or modifications may be made to the present invention as shown in the specific embodiments without departing from the spirit or scope of the invention as broadly described.

Another embodiment of the invention relates to the implementation of the above described various embodiments using hardware and software. It is recognized that the various embodiments of the invention may be implemented or performed using computing devices (processors). A computing device or processor may for example be general purpose processors, digital signal processors (DSP), application specific integrated circuits (ASIC), field programmable gate arrays (FPGA) or other programmable logic devices, etc. The various embodiments of the invention may also be performed or embodied by a combination of these devices.

Further, the various embodiments of the invention may also be implemented by means of software modules, which are executed by a processor or directly in hardware. Also a combination of software modules and a hardware implementation may be possible. The software modules may be stored on any kind of computer readable storage media, for example RAM, EPROM, EEPROM, flash memory, registers, hard disks, CD-ROM, DVD, etc.

## Claims

1. A method for processing a digital signal to be input to a QAM, Quadrature Amplitude Modulation, modulator of the 16QAM type, the method comprising the steps of:
encoding bits of the digital signal according to an LDPC code of the DVB-S2 standard with code rate 2/5 and a block length of 16200 by an encoder
interleaving the encoded bits from the encoder into an interleaving matrix by an interleaver,
permuting the interleaved bits from said interleaver by a demux before being input to the QAM modulator of the 16QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b6; v1=b5; v2=b2; v3=b7; v4=b4; v5=b3; v6=b0; v7=b1.

2. A method for processing a digital signal to be input to a QAM, Quadrature Amplitude Modulation, modulator of the 64QAM type, the method comprising the steps of:
encoding bits of the digital signal according to an LDPC code of the DVB-S2 standard with code rate 2/5 and a block length of 16200 by an encoder
interleaving the encoded bits from the encoder into an interleaving matrix by an interleaver,
permuting the interleaved bits from said interleaver by a demux before being input to the QAM modulator of the 64QAM type, wherein the permuting step is carried out on an 12-bit input word, composed of bits v0, v1, v2, v3, v4, v5, v6, v7, v8, v9, v10 and v1, and generates an 12-bit output word, composed of bits b0, b1, b2, b3, b4, b5, b6, b7, b8, b9, b10 and b11,
wherein v0=b3; v1=b7; v2=b6; v3=b4; v4=b11; v5=b5; v6=b9; v7=b2; v8=b0; v9=b1; v10=b8; v11=b10.

3. A method for processing a digital signal to be input to a QAM, Quadrature Amplitude Modulation, modulator of the 256QAM type, the method comprising the steps of:
encoding bits of the digital signal according to an LDPC code of the DVB-S2 standard with code rate 2/5 and a block length of 16200 by an encoder
interleaving the encoded bits from the encoder into an interleaving matrix by an interleaver,
permuting the interleaved bits from said interleaver by a demux before being input to the QAM modulator of the 256QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b2; v1=b3; v2=b6; v3=b0; v4=b1; v5=b7; v6=b4; v7=b5.

4. A method for processing a digital signal to be input to a QAM, Quadrature Amplitude Modulation, modulator of the 16QAM type, the method comprising the steps of:
encoding bits of the digital signal according to an LDPC code proposed by Sony Corporation with code rate 2/5 and a block length of 16200 by an encoder
interleaving the encoded bits from the encoder into an interleaving matrix by an interleaver,
permuting the interleaved bits from said interleaver by a demux before being input to the QAM modulator of the 16QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b4; v1=b7; v2=b6; v3=b2; v4=b3; v5=b1; v6=b0; v7=b5.

5. A method for processing a digital signal to be input to a QAM, Quadrature Amplitude Modulation, modulator of the 64QAM type, the method comprising the steps of:
encoding bits of the digital signal according to an LDPC code proposed by Sony Corporation with code rate 2/5 and a block length of 16200 by an encoder,
interleaving the encoded bits from the encoder into an interleaving matrix by an interleaver,
permuting the interleaved bits from said interleaver by a demux before being input to the QAM modulator of the 64QAM type, wherein the permuting step is carried out on an 12-bit input word, composed of bits v0, v1, v2, v3, v4, v5, v6, v7, v8, v9, v10 and v1, and generates an 12-bit output word, composed of bits b0, b1, b2, b3, b4, b5, b6, b7, b8, b9, b10 and b11,
wherein v0=b3; v1=b0; v2=b1; v3=b9; v4=b8; v5=b5; v6=b4; v7=b6; v8=b2; v9=b11; v10=b10; v11=b7.

6. A method for processing a digital signal to be input to a QAM, Quadrature Amplitude Modulation, modulator of the 256QAM type, the method comprising the steps of:
encoding bits of the digital signal according to an LDPC code proposed by Sony Corporation with code rate 2/5 and a block length of 16200 by an encoder
interleaving the encoded bits from the encoder into an interleaving matrix by an interleaver,
permuting the interleaved bits from said interleaver by a demux before being input to the QAM modulator of the 256QAM type, wherein the permuting step is carried out on an 8-bit input word, composed of bits v0, v1, v2, v3, v4, v5, v6 and v7, and generates an 8-bit output word, composed of bits b0, b1, b2, b3, b4, b5, b6 and b7,
wherein v0=b3; v1=b2; v2=b7; v3=b0; v4=b4; v5=b1; v6=b5; v7=b6.

7. A system for transmitting a digital signal, comprising an encoder, an interleaver, a demux and a QAM, Quadrature Amplitude Modulation, modulator, adapted to perform the steps of the method according to either of claims 1 to 6.

8. A method for processing a digital signal received and demodulated by a QAM, Quadrature Amplitude Modulation, demodulator of the 16QAM type, the method comprising the steps of:
permuting the demodulated bits of the digital signal from the QAM demodulator by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein
v0=b6; v1=b5; v2=b2; v3=b7; v4=b4; v5=b3; v6=b0; v7=b1,
deinterleaving the permuted bits into a matrix by a deinterleaver, and
decoding the bits in the matrix according to an LDPC code of the DVB-S2 standard with code rate 2/5 and a block length of 16200 by a decoder.

9. A method for processing a digital signal received and demodulated by a QAM, Quadrature Amplitude Modulation, demodulator of the 64QAM type, the method comprising the steps of:
permuting the demodulated bits of the digital signal from the QAM demodulator by a multiplexer block, wherein the permuting step is carried out on an 12-bit input word, composed of bits b0, b1, b2, b3, b4, b5, b6, b7, b8, b9, b10 and b11,
and generates an 12-bit output word, composed of bits v0, v1, v2, v3, v4, v5, v6, v7, v8, v9, v10 and v11, wherein
v0=b3; v1=b7; v2=b6; v3=b4; v4=b11; v5=b5; v6=b9; v7=b2; v8=b0; v9=b1;
v10=b8; v11=b10,
deinterleaving the permuted bits into a matrix by a deinterleaver, and
decoding the bits in the matrix according to an LDPC code of the DVB-S2 standard with code rate 2/5 and a block length of 16200 by a decoder.

10. A method for processing a digital signal received and demodulated by a QAM, Quadrature Amplitude Modulation, demodulator of the 256QAM type, the method comprising the steps of:
permuting the demodulated bits of the digital signal from the QAM demodulator by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein
v0=b2; v1=b3; v2=b6; v3=b0; v4=b1; v5=b7; v6=b4; v7=b5,
deinterleaving the permuted bits into a matrix by a deinterleaver, and
decoding the bits in the matrix according to an LDPC code of the DVB-S2 standard with code rate 2/5 and a block length of 16200 by a decoder.

11. A method for processing a digital signal received and demodulated by a QAM, Quadrature Amplitude Modulation, demodulator of the 16QAM type, the method comprising the steps of:
permuting the demodulated bits of the digital signal from the QAM demodulator by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein
v0=b4; v1=b7; v2=b6; v3=b2; v4=b3; v5=b1; v6=b0; v7=b5,
deinterleaving the permuted bits into a matrix by a deinterleaver, and
decoding the bits in the matrix according to an LDPC code proposed by Sony Corporation with code rate 2/5 and a block length of 16200 by a decoder.

12. A method for processing a digital signal received and demodulated by a QAM, Quadrature Amplitude Modulation, demodulator of the 64QAM type, the method comprising the steps of:
permuting the demodulated bits of the digital signal from the QAM demodulator by a multiplexer block, wherein the permuting step is carried out on an 12-bit input word, composed of bits b0, b1, b2, b3, b4, b5, b6, b7, b8, b9, b10 and b11,
and generates an 12-bit output word, composed of bits v0, v1, v2, v3, v4, v5, v6, v7, v8, v9, v10 and v11, wherein
v0=b3; v1=b0; v2=b1; v3=b9; v4=b8; v5=b5; v6=b4; v7=b6; v8=b2; v9=b11; v10=b10; v11=b7,
deinterleaving the permuted bits into a matrix by a deinterleaver, and
decoding the bits in the matrix according to an LDPC code proposed by Sony Corporation with code rate 2/5 and a block length of 16200 by a decoder.

13. A method for processing a digital signal received and demodulated by a QAM, Quadrature Amplitude Modulation, demodulator of the 256QAM type, the method comprising the steps of:
permuting the demodulated bits of the digital signal from the QAM demodulator by a multiplexer block, wherein the permuting step is carried out on an 8-bit input word, composed of bits b0, b1, b2, b3, b4, b5, b6 and b7, and generates an 8-bit output word, composed of bits v0, v1, v2, v3, v4, v5, v6 and v7, wherein
v0=b3; v1=b2; v2=b7; v3=b0; v4=b4; v5=b1; v6=b5; v7=b6 ,
deinterleaving the permuted bits into a matrix by a deinterleaver, and
decoding the bits in the matrix according to an LDPC code proposed by Sony Corporation with code rate 2/5 and a block length of 16200 by a decoder.

14. A system for receiving a digital signal, comprising a QAM, Quadrature Amplitude Modulation, demodulator, a multiplexer block, a deinterleaver and a decoder, adapted to perform the steps of the method according to either of claims 8 to 13.
